# EUROPEAN PATENT APPLICATION

(11) **EP 0 734 081 A1**
(43) Date of publication of application: **25.09.1996**
(21) Application number: 96104351.0
(22) Date of filing: 19.03.1996
(51) Int. Cl.: H01L 39/24

(54) **Oxide superconducting wire and manufacturing method**

(30) Priority: 23.03.1995 JP 63707/95
(71) Applicant: HITACHI, LTD., Chiyoda-ku, Tokyo 101 (JP)
(72) Inventor: Doi, Toshiya, Hitachioota-shi, Ibaraki 313 (JP); Ozawa, Takeshi, Hitachi-shi, Ibaraki 317 (JP); Yuasa, Toyotaka, Hitachi-shi, Ibaraki 316 (JP); Higashiyama, Kazutoshi, Naka-gun, Ibaraki 311-01 (JP)
(74) Representative: Strehl Schübel-Hopf Groening & Partner

(57) **Abstract**

A superconducting wire comprises a composite of the metallic substance and superconducting substance, wherein the superconducting substance is split by the metallic substance into a plurality of superconducting substance elements which are parallel to the wire in its longitudinal direction, the cross section perpendicular to the superconducting substance elements in the longitudinal direction has a flat form where the brachyaxis over macro-axis is equal to or smaller than 1.0, without the length of the brachyaxis exceeding 5 microns, the metallic substance is composed of silver, silver alloy or ceramics-reinforced silver, and chemical composition of the superconducting substance is expressed by:

(Tlₓ₁Pbₓ₂Biₓ₃Hgₓ₄Cuₓ₅)(Sr₁₋ₓ₆Baₓ₆)₂Caₙ₋₁CuₙO₂ₙ₊₃₊ₓ₇

where
0 ≦ X1 ≦ 1.0,
0 ≦ X2 ≦ 1.0,
0 ≦ X3 ≦ 0.5,
0 ≦ X4 ≦ 1.0,
0 ≦ X5 ≦ 1.0,
0.5 ≦ X1 + X2 + X3 + X4 + X5 ≦ 1,
0 ≦ X6 ≦ 1,
-0.5 ≦ X7 ≦ 0.5
n = 1, 2, 3, 4, 5.

## Description

### BACKGROUND OF THE INVENTION

### Industrial Field Of Application

The present invention relates to the configuration of the superconducting wire comprising the oxide superconducting substance, and its manufacturing method. More particularly, it relates to the superconducting wire which permits high-density superconductive critical current (Jc) to be applied in the magnetic field.

### Description Of The Prior Art

Since the first oxide superconducting substance was discovered in 1986, more than several tens of types of oxide superconducting substances have been discovered. Among them, the oxide superconducting substances which have been studied to achieve commercial use for the reason of substance stability and ease of synthesis can be narrowed down to the following four types:
(Tl₁₋ₓ₁₋ₓ₂Pbₓ₁Biₓ₂)(Sr₁₋ₓ₃Baₓ₃)₂Caₙ₋₁CuₙO₂ₙ₊₃ (1)

   where
   0 ≦ X1 ≦ 0.9
   0 ≦ X2 ≦ 0.5
   0 ≦ X1 + X2 ≦ 1,
   0 ≦ X3 ≦ 1,
   n = 1, 2, 3, 4, 5
   (hereinafter abbreviated as single Tl-0 layered system)
Tl₂Ba₂Caₙ₋₁CuₙO₂ₙ₊₄ (2)

   where n = 1, 2, 3, 4, 5
   (hereinafter abbreviated as double Tl-0 layered system)
(Bi_{l-Xl}Pbₓ₁)₂Sr₂Caₙ₋₁CuₙO₂ₙ₊₄ (3)

   where 0 ≦ X1 ≦ 0.4,
   n = 1, 2, 3
   (hereinafter abbreviated as double Bi-0 layered system)
LnBa₂Cu₃O_{7+X1} (4)

   where Ln is Y or rare earth.
   -0.5 ≦ X1 ≦ 0.1,
   (hereinafter abbreviated as Y system)

Of these types, double Bi-0 layed superconducting substances are easily subjected to crystal orientation (orientation of crystal in a specific direction, providing excellent flow of superconductive current at the crystalline boundary; hence, it has a high superconductive transport current density (transport Jc) in the non-magnetic environment (Japanese Journal of Applied Physics, Vol. 30, 1991, pp. 2083 - L2084). As a specific method for manufacturing high temperature superconducting wire, a silver sheath method is excellent in industrial productivity, and is the main stream at present, as introduced in the Japanese Journal of Applied Physics (Vol. 62, Part 5, 1993, p455). Because of intrinsic problems resulting from its crystal structure, however, this substance system has a crucial problem of very small pinning force in the temperature range where cooling by liquid nitrogen is possible (Physics C, Vol 177, 1991, pp. 431 - 437). Accordingly, it is possible to manufacture the high-quality superconducting wire to be used at the temperature below 40 K, but this substance could not be used to manufacture the wire to be utilized at the temperature of 60 K and over.

The single Tl-0 layered superconducting substances, double Tl-0 layered superconducing substances and Y based superconducting substances allow high pinning force to be exhibited up to the temperature range in the vicinity of the critical temperature (Tc). However, it is difficult to ensure uniform crystal orientation, and this results in poor flow of superconductive current at the crystalline boundary. No one has succeeded in obtaining the superconducting wire with the transport Jc exceeding 10,000 A/cm² at the temperature of 77 K and magnetic field of 1T which is considered to provide a standard essential to the commercial use up to the present time (Physics C, Vol. 220, 1994, pp. 310 - 322, Hitachi Review, Vol. 39, 1990, p. 55, Japanese Journal of Applied Physics, Vol. 27, 1988, pp. L185 - L187).

In the temperature range where cooling by liquid nitrogen is possible, it has been impossible to manufacture the superconducting wire which has the performances meeting the requirements in commercial use. There has been no superconducting equipment which can be operated by cooling with the refrigerant having the boiling point higher than that of liquid helium such as liquid nitrogen.

In the prior arts discussed above, the art of using double Bi-0 layered superconducting substances has a problem of weak pinning force at 77K. In the temperature range of not less than 60 K, it has a problem of substantial reduction in critical current density, when the magnetic field is applied to the double Bi-0 layered superconducting substance. These problems have impeded their use for the superconducting equipment cooled for operation by liquid nitrogen.

The above mentioned prior art has failed to provide longer superconducting wire products because of lack of sufficient study on the properties of the substrate to be made composite with the superconducting substance. Furthermore, manufacture of the superconducting wire has required much time and efforts, resulting in excessive mass production costs.

### SUMMARY OF THE INVENTION

The object of the present invention is to have crystals of the oxide superconducting substance oriented in a preferred direction at a reduced cost, thereby providing the superconducting wire having a high critical current density even in the magnetic field. Furthermore, it is also the object of the present invention to provide the equipment using superconducting material such as the superconducting magnet, NMR equipment, MRI equipment, magnetic levitated train, superconducting generator, energy storage device, magnetic shield equipment, synchrotron radiation equipment and elementary particle accelerator; these devices operating in the temperature range above the temperature which allows cooling by liquid nitrogen can be manufactured by the technique provided only by the present invention.

The above object can be attained by thermally treating in a metallic sheath with the crystal oriented in a specific direction, the superconducting substance having a sufficiently high pinning force even in the temperature range allowing cooling by liquid nitrogen.

The metallic sheath is preferred to be made of silver, silver alloy, or silver having ceramics dispersed therein in view of reaction characteristics with superconducting substance.

As for the direction in which the silver crystal used as the metallic sheath is oriented, there is fundamentally no problem regardless of which crystal surface is oriented in which direction. The most preferred is (1) the case where surface {100} of the silver crystal is parallel to the boundary between the oxide superconducting substance and metallic sheath, and direction 〈001〉 of the silver crystal is oriented parallel to the superconducting wire in its longitudinal direction. The second most preferred is (2) the case where surface {110} of the silver crystal is parallel to the boundary between the oxide superconducting substance and metallic sheath, and direction 〈211〉 of the silver crystal is oriented parallel to the superconducting wire in its longitudinal direction. In the case of (1), the oxide superconducting substance is influenced by the orientation of silver crystal through heat treatment inside the metallic sheath, so that the c-axis of the crystal is perpendicular to the boundary between the oxide superconducting substance and metallic sheath, and the a-axis (it may be b-axis in the case of Y-based superconducting substance) is parallel to the superconducting wire in the longitudinal direction; such excellent orientation is obtained as a result. Even when silver crystal is oriented as in (2), the superconducting substance is oriented in the same way though to a slightly less degree. This provides the wire having a very high Jc value.

To ensure uniform orientation of the silver crystal as shown in (1), the drawing step and/or flattening step in the process of manufacturing the superconducting wire should be kept at the temperature of 100 to 250 degrees Celsius. The silver used in metallic sheath comes to have so-called cubic texture, by annealing at the temperature of not less than 400 degrees Celsius after processing at this temperature. The cubic texture refers to {100} 〈001〉 orientation texture, as described, for example, in Shinichi Nagashima ("Texture", pp. 133 - 185, Maruzen Co., Ltd.). Furthermore, in order to get uniform orientation of silver crystal as in the case of (2), the drawing step and/or flattening step in the process of manufacturing the superconducting wire should be kept at the temperature of 50 to 100 degrees Celsius. Then the silver used in metallic sheath comes to have the intended orientation by annealing at the temperature of at least 300 degrees Celsius after processing at this temperature.

When the superconducting wire is actually manufactured, the powder of the superconducting substance filled in the silver tube is required to be bonded sufficiently. This makes it necessary for heat treatment temperature to be kept not less than 700 degrees Celsius, more preferable not less than 800 degrees Celsius. The optimum temperature for heat treatment at this time varies by dozens of degrees according to the composition of the superconducting substance and the atmosphere for heat treat (mainly partial pressure of oxygen).

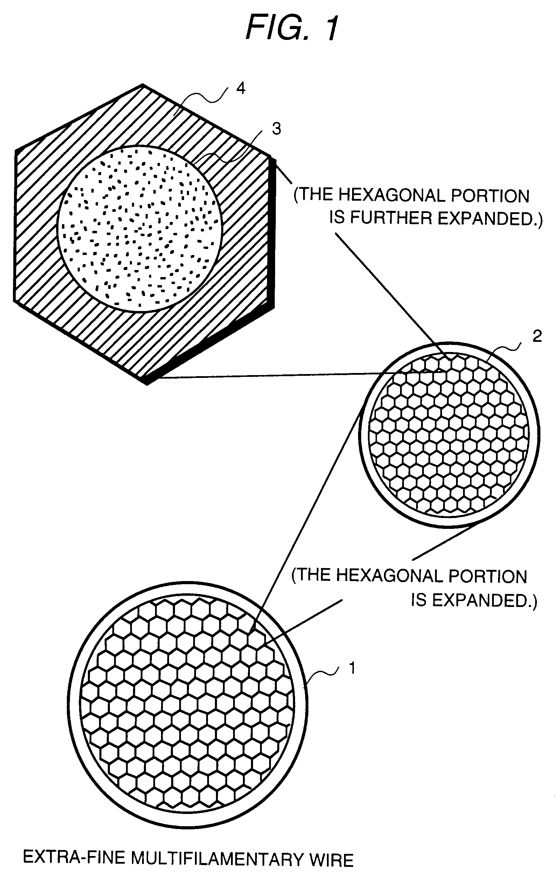

Fig. 1 illustrates the structure of the cross section of the superconducting wire used in experiment according to the present invention. Numeral 1 denotes the metal layer to reinforce the whole superconducting wire; it is made of silver highly reinforced by finely dispersed MgO. Numeral 2 shows the metal layer which bundles the superconducting filament; this is made of pure silver. Numeral 3 denotes the oxide superconducting substance, and 4 the pure silver. The total length of the wire is 50 m, and has been confirmed to be uniform in the longitudinal direction (perpendicular to the cross section). When the orientation of the silver crystal is as shown in (1) or (2), Jc exhibited a sudden decrease if the diameter of the superconducting portion exceeded 5 microns.

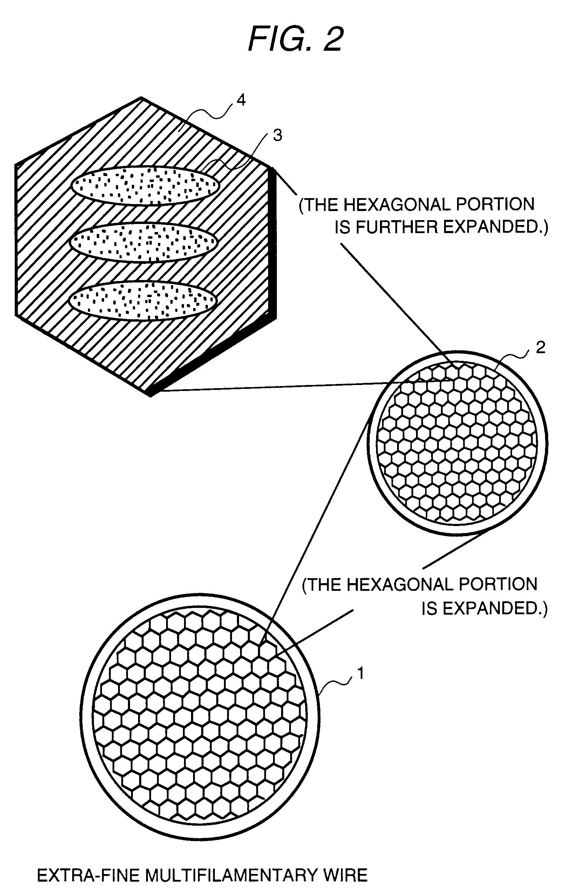

Fig. 2 illustrates the cross section of the superconducting wire used in experiment according to the present invention; it has a different cross section structure. The flatness of the superconducting portion was varied by changing the processing conditions variously. When the length of the brachyaxis (thickness of 3) exceeded 5 microns, the Jc value started to decrease. When it exceeded 10 microns, Jc exhibited a sudden decrease. Furthermore, if the length of the brachyaxis became less than 0.5 microns, Jc decreased. However, this is due to the processing skill. If the portion 3 is reduced too much in thickness, the wire will be broken in the longitudinal direction. If processing is possible at all, portion 3 is considered to be as thin as it could be. The length of the macro-axis (width of 3) was studied up to 100 microns. It was found out that there was no impact on Jc in particular. The length of the macro-axis has been found to give no impact to the orientation of the superconducting substance crystal.

Numeral 4 shows the Ag-Au alloy, Ag-Pd alloy, Ag-Cu alloy and silver reinforced with MgO particles not exceeding 1 micron. The present invention have got the performance (Jc) equivalent to that of the case using the pure silver.

Even if portion 3 is superconducting substance expressed by the following chemical composition:

(Tl_{X1}Pb_{X2}Bi_{X3}Hg_{X5}Cu_{X5})(Sr_{1-X6}BA_{X6})₂Caₙ₋₁CuₙO_{2n+3+X7}

where
0 ≦ X1 ≦ 1.0,
0 ≦ X2 ≦ 1.0,
0 ≦ X3 ≦ 0.5,
0 ≦ X4 ≦ 1.0,
0 ≦ X5 ≦ 1.0,
0.5 ≦ X1 + X2 + X3 + X4 + X5 ≦ 1,
0 ≦ X6 ≦ 1,
-0.5 ≦ X7 ≦ 0.5
n = 1, 2, 3, 4, 5,
and even if the superconducting substance is expressed by the following chemical composition:

LnBa₂Cu₃O_{7+X1}

wherein, Ln is Y or one or more elements selected from rare earth elements, and
-0.5 ≦ X1 ≦ 0.2
n = 1, 2, 3,
the same results have been obtained.

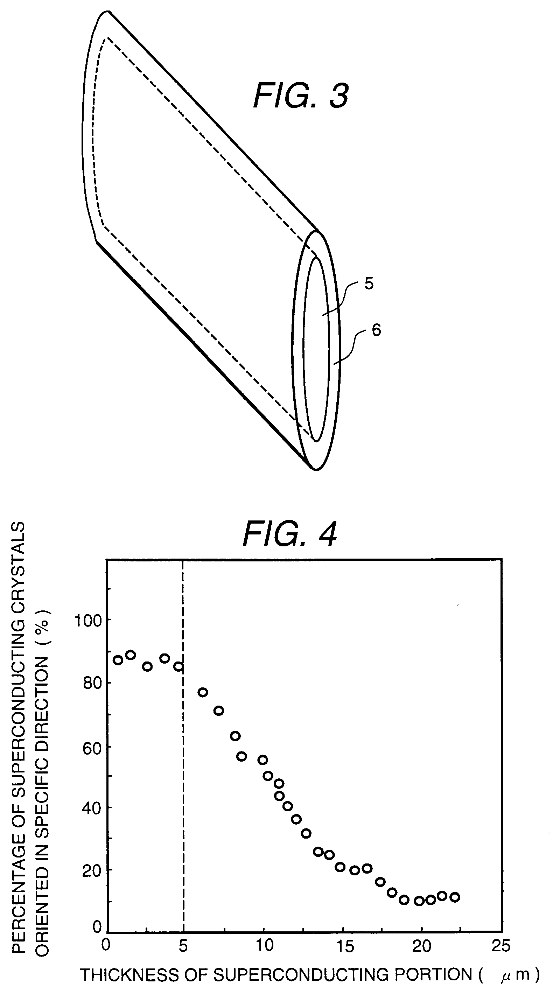

The superconducting wire having the structure shown in Fig. 3, was manufactured in order to study the relationship between the flatness of the superconducting filament and Jc, between the thickness of the superconducting substance portion and Jc, between the orientation of silver crystal on the metallic portion of the superconducting filament and Jc, and between the orientation of the superconducting crystal and Jc.

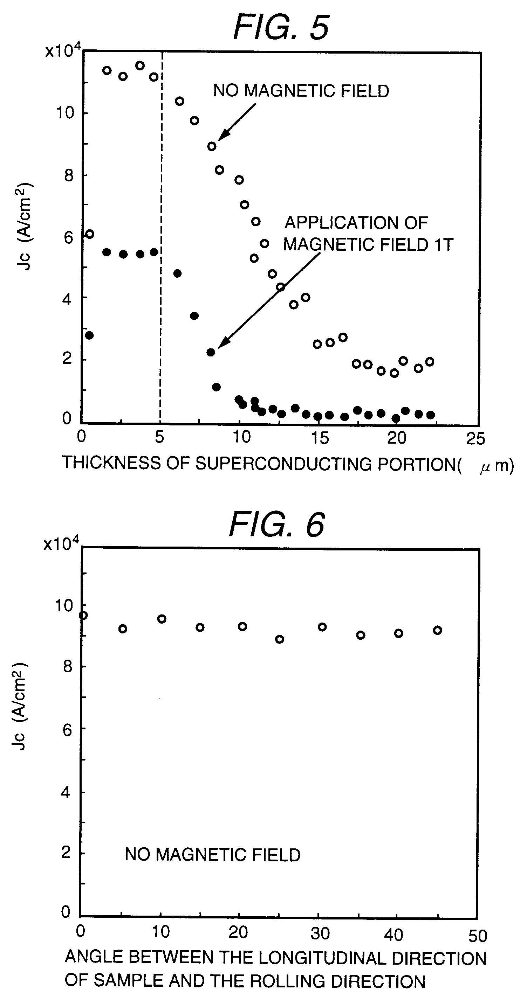

Fig. 4 shows the relationship between the thickness of the superconducting portion (length of the brachyaxis) and the percentage of the crystals where the c-axis of the superconducting substance is perpendicular to the tape surface without exceeding 5 degrees, and the a-axis is oriented parallel in the longitudinal direction without exceeding 10 degrees. Fig. 5 shows the relationship between the thickness of a superconducting portion and Jc. Figs. 4 and 5 show that a high Jc value is obtained when the thickness of the superconducting portion does not exceed 5 microns.

Fig. 6 shows the Jc values varied according to the angle formed between the silver crystal and rolling direction, in other words, between the direction where the superconducting crystal is oriented and the superconducting wire. It can be seen that the Jc value is not affected by the angle formed between the direction where the superconducting crystal is oriented and the superconducting wire.

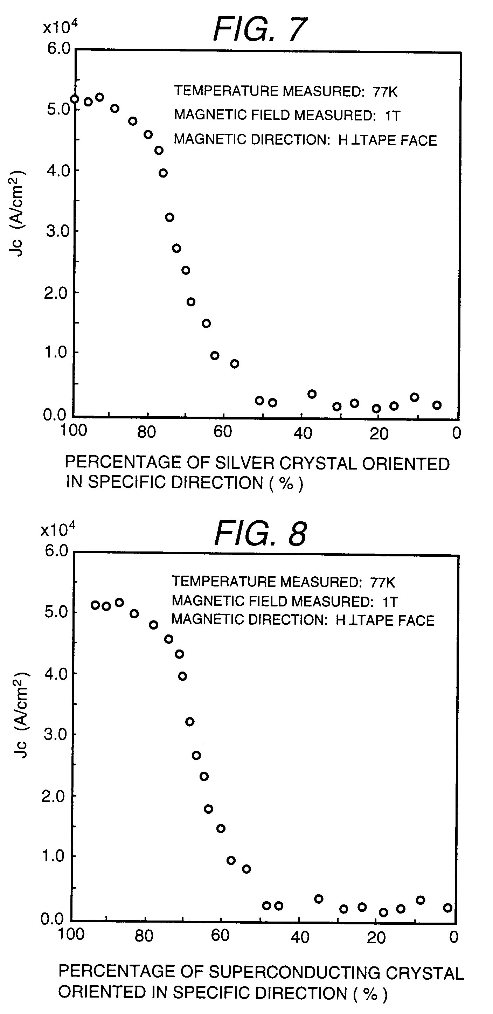

Fig. 7 shows the relationship between the Jc values and the percentage of the silver crystal where the surface {100} is parallel to the tape surface and the direction 〈100〉 is parallel to the rolling direction. As can been seen, the critical current density in the magnetic field is substantially reduced when the percentage of the silver crystal (percentage of the cubic aggravate structure) where the surface {100} is parallel to the tape surface, and direction 〈100〉 is parallel to the rolling direction is reduced below 80 percent. It can been seen that the percentage of the silver crystal where the surface {100} is parallel to the tape surface and the direction 〈100〉 is parallel to the rolling direction (percentage of the cubic texture) must be at least 80 percent, in order to manufacture the high-quality superconducting wire.

Fig. 8 shows the relationship between the Jc values and percentage of the crystal where the c-axis of the superconducting crystal is perpendicular to the boundary with silver without exceeding 5 degrees, and the a-axis does not exceed 10 degrees with respect to the direction 〈100〉 of the silver crystal forming a cubic texture.

Figs. 7 and 8 show that the Jc value is reduced when the percentage of the silver crystal being oriented in a specific direction is below 80 percent. They also indicate that the Jc value is reduced when the percentage of the superconducting substance crystal being oriented in a specific direction is below 80 percent.

Fig. 9 illustrates the relationship between the wire drawing and rolling temperature, and magnetic field at 77 K. It is noted that the rolling temperature is prefereable to be 50 - 250°C

The present inventors have found out that, in the manufacture of superconducting wires, higher Jc values can be obtained when a-, b- and c-axes of the superconducting substance crystal are all oriented in the same direction (tri-axial orientation). The present inventors have found out a method for manufacturing the superconducting wire having a higher Jc value by tri-axial orientation of the superconducting substance.

Since the structure of the silver located around the superconducting substance is oriented in a specific direction in superconducting wire according to the present invention, growth takes place while the direction of the superconducting substance crystal is being influenced by the orientation of the silver crystal at the portion where the silver and superconducting substance are in contact with each other. Accordingly, when the silver structure is oriented in a specific direction, superconducting substance is subjected to tri-axial orientation, resulting in a very high Jc value to be ensured in the superconducting wire according to the present invention.

In place of pure silver, the inventors have used silver/gold alloy, silver/palladium alloy, silver/copper alloy, alloy reinforced with MgO dispersed on the silver matrix phase, and alloy reinforced with intermetallic compound dispersed on the silver matrix phase --- all having cubic texture. High Jc values have been obtained from this attempt.

### BRIEF DESCRIPTION Of THE DRAWINGS

Fig. 1 is a schematic drawing representing the superconducting wire according to one embodiment of the present invention;
Fig. 2 is a schematic drawing representing the superconducting wire according to another embodiment of the present invention;
Fig. 3 is a schematic drawing representing the superconducting wire according to still another embodiment of the present invention;
Fig. 4 is a drawing showing the relationship between the thickness of the superconducting portion (length of the brachyaxis) and the percentage of the superconducting substance crystal;
Fig. 5 is a drawing showing the relationship between the thickness of the superconducting portion and Jc;
Fig. 6 is a drawing showing the relationship between Jc and the angle formed between the direction in which superconducting crystal is oriented and superconducting wire;
Fig. 7 is a drawing showing the relationship between Jc and the percentage of the silver crystal of the superconducting substance;
Fig. 8 is a drawing showing the relationship between Jc and the percentage of the superconducting crystal;

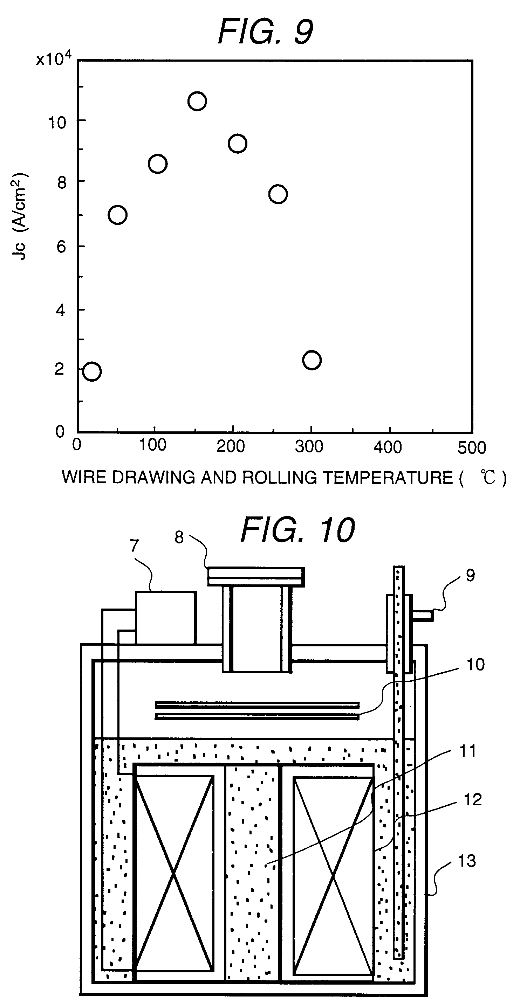

Fig. 9 is a drawing showing the relationship between wire drawing and rolling temperatures, and Jc at 77 K in the non-magnetic field environment;
Fig. 10 is a schematic drawing representing the superconducting magnet manufactured according to the present invention; and

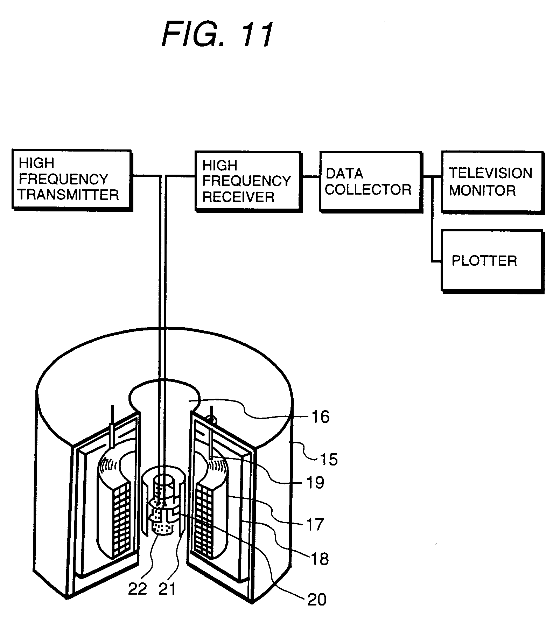

Fig. 11 is a schematic drawing representing the NMR device manufactured according to the present invention.

### DESCRIPTION OF EMBODIMENTS

The following gives concrete description of embodiments of the present invention:

### [First Embodiment]

The inventors have manufactured superconducting substance powder. PbO, BaO, SrO, CaO and CuO powders having a purity of 99 percent or more were mixed in order to get Pb : Ba : Sr: Ca : Cu = 0.5 : 0.4 : 1.6 : 2 : 3 in terms of atomic ratio. This powder mixture was put into an alumina-made crucible, and was baked at the temperature of 800 degrees Celsius in the flowing atmosphere of 20 percent oxygen and 80 percent nitrogen for 24 hours. This was crushed in the globe filled with 100 percent nitrogen gas. Tl₂O₃ was added in the same molar quantity as Pb, and was mixed sufficiently. This powder was put into a alumina-made crucible with cover, and was calcined at the temperature of 880 degrees Celsius in the flowing atmosphere of 20 percent oxygen and 80 percent nitrogen for 24 hours. This powder was put into the silver pipe having a purity of 99.998% (with an inner diameter of 4 mm and outer diameter of 6 mm). This was kept at the temperature of 160 degrees Celsius, and was wire-drawn by the draw bench to get the outer diameter of 1.5 mm. Then it was rolled to a thickness of 0.07 mm with the temperature kept at 160 degrees Celsius. This was cut into tape-formed samples having a length of 5 cm. This was treated in the flowing atmosphere of 20 percent oxygen and 80 percent nitrogen. As conditions for heat treatment, the sample was heated from the room temperature to 800 degrees Celsius for three hours, and from 800 to 880 degrees Celsius for two hours. It was held at 880 degrees Celsius for 48 minutes and cooled down to the room temperature in ten hours. Fig. 3 is a schematic drawing of the superconducting wire sample. Numeral 5 in the drawing denotes a superconducting substance, and 6 shows the silver.

The cross section was inspected by the light microscope and scanning electron microscope (SEM) to find out that the superconducting portion was 4 ±0.5 microns thick and 8 ±0.2 mm wide.

The inventors studied the orientation of the silver crystal on the surface of the sample surface by X-ray diffraction after heat treatment. It was confirmed that the surface {100} of 90 percent crystal particle was parallel to the tape surface, and direction 〈100〉 was parallel to the rolling direction (i.e. parallel to the tape-formed wire in the longitudinal direction).

Furthermore, the inventors removed the external silver to study the orientation of the crystal of the internal superconducting substance by X-ray diffraction. It was confirmed that the c-axis of the crystal accounting for over 85 percent of the superconducting substance was perpendicular to the tape surface without exceeding 5 degrees, and the a-axis was parallel to the longitudinal direction without exceeding 10 degrees.

DC 4-terminal method was used to measure the superconductive critical current density (Jc) of the sample after heat treatment. Jc was 120,000 A/cm² at 77 K at the zero magnetic field, and was 60,000 A/cm² when lT magnetic field was applied perpendicular to the tape.

### [Second Embodiment]

Powdered superconducting substance manufactured according to the first embodiment was filled in the silver pipe, as in the first embodiment. This was kept at the temperature of 100 degrees Celsius, and was wire-drawn by the draw bench to get the outside diameter of 1.5 mm. After that, it was rolled to a thickness of 0.07 mm, and was cut to a length of 5 cm. This was heat-treated in the flowing atmosphere of 20 percent oxygen and 80 percent nitrogen. Temperature conditions for heat treatment the same as First Embodiment.

The inventors studied the cross section using the light microscope and scanning electron microscope (SEM) to find out that the superconducting portion was 4 ±0.5 microns thick and 8 ±0.2 microns wide.

The inventors studied the orientation of the silver crystal of the sample surface by X-ray diffraction after heat treatment. It was confirmed that the surface {110} of 90 percent crystal particle was parallel to the tape surface, and direction 〈211〉 was parallel to the rolling direction.

Furthermore, the inventors removed the external silver to study the orientation of the crystal of the internal superconducting substance by X-ray diffraction. It was confirmed that the c-axis of the crystal accounting for over 80 percent of the superconducting substance was perpendicular to the tape surface without exceeding 5 degrees, and the a-axis was parallel to the direction 〈100〉 of the silver crystal, without exceeding 10 degrees.

DC 4-terminal method was used to measure the superconductive critical current density (Jc) of the sample after heat treatment. Jc was 110,000 A/cm² at 77 K at the zero magnetic field, and was 50,000 A/cm² when lT magnetic field was applied perpendicular to the tape.

### [Comparative Example 1]

Powdered superconducting substance manufactured according to the first embodiment was filled in the silver pipe, as in the first embodiment. This was put in the room having a room temperature of 20 degrees Celsius where it was annealed at 400 degrees Celsius for each wire drawing for one hour. While it was annealed, it was wire-drawn by the draw bench to get the outside diameter of 1.5 mm. After that, it was annealed at 400 degrees Celsius for one hour for each rolling. While being annealed, it was rolled to a thickness of 0.07 mm, and was cut to a length of 5 cm. This was heat-treated in the flowing atmosphere of 20 percent oxygen and 80 percent nitrogen. Temperature conditions for heat treatment the same as First Embodiment.

The inventors studied the cross section using the light microscope and scanning electron microscope (SEM) to find out that the superconducting portion was 4 ±0.5 microns thick and 8 ±0.2 mm wide.

The inventors studied the orientation of the silver crystal on the surface of the sample surface by X-ray diffraction after heat treatment. It was confirmed that silver crystal was oriented in random direction, without any specific crystal surface being oriented in the specific direction.

Furthermore, the inventors removed the external silver to study the orientation of the crystal of the internal superconducting substance by X-ray diffraction. It was confirmed that the c-axis of the crystal accounting for over 80 percent of the superconducting substance was perpendicular to the tape surface without exceeding 5 degrees, but the a-axis was not oriented in any particular direction.

DC 4-terminal method was used to measure the superconductive critical current density (Jc) of the sample after heat treatment. Jc was 30,000 A/cm² at 77 K at zero magnetic field, and was 2,000 A/cm² when lT magnetic field was applied perpendicular to the tape.

As can be seen from the first and second embodiments and comparative example 1, the orientation of the silver crystal and superconducting crystal is important to get a high Jc value.

### [Third Embodiment]

The inventors have manufactured powdered superconducting substance as in the first embodiment and it was filled in the similar silver pipe. This was wire-drawn at the room temperature by draw bench to get the outside diameter of 1.5 mm. After that, it was kept at 160 degrees Celsius and was rolled to various thicknesses. It was cut into tape-formed samples having a length of 5 cm, and was heat-treated as in the first embodiment.

The inventors studied the cross section of various samples using the light microscope and scanning electron microscope (SEM) to measure the thickness of the superconducting portions.

The inventors studied the orientation of the silver crystal of the surface of the sample by X-ray diffraction after heat treatment. It was confirmed in all samples that the surface {100} of 85 percent crystal particle was parallel to the tape surface, and direction 〈100〉 was parallel to the rolling direction (i.e. parallel to the tape-formed wire in the longitudinal direction).

Furthermore, the inventors removed the enteral silver to study the orientation of the crystal of the internal superconducting substance by X-ray diffraction. They checked the percentage of the crystal where the c-axis of the superconducting substance was perpendicular to the tape surface without exceeding 5 degrees, and the a-axis was parallel in the longitudinal direction, without exceeding 10 degrees. Fig. 4 shows the thickness (length of the brachyaxis) of superconducting portions and the percentage of the crystals where the a-axis of the superconducting substance is perpendicular to the tape surface without exceeding 5 degrees, and the a-axis is oriented parallel in the longitudinal direction without exceeding 10 degrees.

DC 4-terminal method was used to measure the superconductive critical current density (Jc) of the sample after heat treatment. Measurement was made at temperature of 77 K at zero magnetic field when lT magnetic field was applied perpendicular to the tape. Fig. 5 shows the relationship between the thickness of superconducting portion and Jc.

Figs. 4 and 5 show that a high Jc value can be obtained when the thickness of the superconducting portion does not exceed 5 microns.

### [Fourth Embodiment]

The inventors manufactured samples in the same manner as in the second embodiment, except that the rolling direction was shifted from the longitudinal direction of the tape-formed sample in increments of 5 degrees.

The inventors studies the orientation of the silver crystal of the surface of the sample by X-ray diffraction after heat treatment. It was confirmed in all samples that the surface {100} of 85 percent crystal particle was parallel to the tape surface, and direction 〈211〉 was parallel to the rolling direction (not matched in the longitudinal direction of the tape).

Furthermore, the inventors removed the external silver to study the orientation of the crystal of the internal superconducting substance by X-ray diffraction. It was confirmed that the c-axis of the crystal accounting for over 80 percent of the superconducting substance was perpendicular to the tape surface without exceeding 5 degrees, and the a-axis is oriented parallel to direction 〈100〉 of the silver crystal without exceeding 10 degrees.

DC 4-terminal method was used to measure the superconductive critical current density (Jc) of the sample after heat treatment, at the temperature of 77 K in the non-magnetic field environment.

Fig. 6 shows the Jc value is not affected by the angle formed between the silver crystal and rolling direction, in other words, between the direction where the superconducting crystal is oriented and the superconducting wire.

### [Fifth Embodiment]

In place of pure silver used in the first embodiment, the inventors used Ag-40% Au alloy, Ag-20% Au alloy, Ag-10% Pb alloy, Ag-10% Cu alloy, and alloy reinforced with dispersed MgO having a particle diameter of 0.1 microns which was 0.1 percent in terms of volume fraction as Ag matrix phase, and manufactured the superconducting wire samples in the same way as the first embodiment. The performances on the same level as those obtained in embodiment 1 (below 80 percent in Jc) were obtained in all cases.

### [Sixth Embodiment]

Based on the procedure of the first embodiment but with some modifications in wire drawing and rolling conditions, inventors manufactured samples with changes in the percentage of the silver crystal where surface {100} is parallel to the tape surface and direction 〈100〉 is parallel to the rolling direction.

Fig. 7 shows the relationship between the Jc and the percentage of the silver crystal where surface {100} is parallel to the tape surface and direction 〈100〉 is parallel to the rolling direction. As can be seen from the drawing, when the percentage of silver crystal where surface {100} is parallel to the tape surface 4 and direction 〈100〉 is parallel to the direction of rolling (the percentage of cubic texture) is 80 percent or less, there is a substantial decrease in critical current density in the magnetic field. Accordingly, to manufacture the high-quality superconducting wire, it is necessary to ensure that the percentage of silver crystal where surface {100} is parallel to the tape surface and direction 〈100〉 is parallel to the direction of rolling (cubic texture) is over 80 percent.

Furthermore, Fig. 8 shows the relationship between Jc and percentage of the crystal where the c-axis of the superconducting crystal is perpendicular to the boundary with silver without exceeding 5 degrees, and the a-axis does not exceed 10 degrees with respect to the direction 〈100〉 of the silver crystal forming a cubic texture.

Figs. 7 and 8 show that the Jc value is reduced when the percentage of the silver crystal being oriented in a specific direction is below 80 percent. They also indicate that the Jc value is reduced when the percentage of the superconducting substance crystal being oriented in a specific direction is below 80 percent.

### [Seventh Embodiment]

Powdered superconducting substance manufactured in the first embodiment was filled in the silver pipe having a purity of 99.998%. This was kept at the temperature of 160 degrees Celsius, and was wire-drawn by the draw bench to get the outer diameter of 1.5 mm. Fifty five of the resulting wires were bundled and put into the silver pipe, which was again kept at the temperature of 160 degrees Celsius, and was wire-drawn by the draw bench to get the outer diameter of 1.5 mm. Fifty-five of these primary wires were bundled and were put into the silver pipe highly reinforced by finely dispersed MgO. It was again kept at 160 degrees Celsius, and was wire-drawn by the draw bench to get the outer diameter of 1.5 mm. This was cut to a length of 5 cm. This was treated in the flowing atmosphere of 20 percent oxygen and 80 percent nitrogen. As conditions for heat treatment, the sample was heated from the room temperature to 800 degrees Celsius for three hours, and from 800 to 880 degrees Celsius for two hours. It was held at 880 degrees Celsius for 48 minutes and cooled down to the room temperature in ten hours. Fig. 1 is a schematic drawing of the superconducting wire sample. Numeral 1 in the drawing denotes the silver highly reinforced by finely dispersed MgO. Numerals 2 and 4 indicate silver, and 3 the oxide superconducting substance.

The inventors studied the cross section using a scanning electron microscope (SEM) to find out that the diameter of the superconducting portion of one filament was 4 ±0.5 microns.

The inventors studied the orientation of the silver crystal of the filament by X-ray diffraction after heat treatment. It was confirmed that the surface {100} of 80 percent crystal particle was parallel to the boundary with the superconducting portion, and direction 〈100〉 was parallel to the wire in the longitudinal direction.

DC 4-terminal method was used to measure the superconductive critical current density (Jc) of the sample after heat treatment. Jc was 90,000 A/cm² at 77 K at zero magnetic field, and was 40,000 A/cm² when lT magnetic field was applied perpendicular to the tape.

### [Eighth Embodiment]

The wire before heat treatment, manufactured in the seventh embodiment was kept at the temperature of 160 degrees Celsius, and was rolled in the longitudinal direction. This was cut into tape-formed samples having a length of 5 cm, and was treated in the flowing atmosphere of 20 percent oxygen and 80 percent nitrogen. As conditions for heat treatment, the sample was heated from the room temperature to 800 degrees Celsius for three hours, and from 800 to 880 degrees Celsius for two hours. It was held at 880 degrees Celsius for 48 minutes and cooled down to the room temperature in ten hours.

The inventors studied the cross section using the scanning electron microscope (SEM) to find out that the superconducting portion of one filament was 2 ±0.2 microns thick (long at the brachyaxis portion).

The inventors studied the orientation of the silver crystal of the filament by X-ray diffraction after heat treatment. It was confirmed that the surface {100} of 80 percent crystal particle was parallel to the boundary with the superconducting portion, and direction 〈100〉 was parallel to the wire in the longitudinal direction.

DC 4-terminal method was used to measure the superconductive critical current density (Jc) of the sample after heat treatment. Jc was 150,000 A/cm² at 77 K at zero magnetic field, and was 80,000 A/cm² when 1T magnetic field was applied perpendicular to the tape.

### [Ninth Embodiment]

The inventors manufactured the filament having the cross section illustrated in Fig. 2, according to the procedure of the seventh embodiment.

The inventors studied the cross section using the scanning electron microscope (SEM) to find out that the superconducting portion of one wire was 2 ±0.2 microns thick (long at the brachyaxis portion).

DC 4-terminal method was used to measure the superconductive critical current density (Jc) of the sample after heat treatment. Jc was 140,000 A/cm² at 77 K at zero magnetic field, and was 75,000 A/cm² when 1T magnetic field was applied perpendicular to the tape.

### [Tenth Embodiment]

Based on the procedure of the first embodiment, inventors manufactured the superconducting wire at the heat treatment temperature optimized in the range of 30 degrees Celsius, using various superconducting substances. Superconducting substances had the following compositions:

(TlₓPbₓ₂Biₓ₃Hgₓ₄Cuₓ₅)(Sr₁₋ₓ₆Baₓ₆)₂Caₙ₋₁CuₙO₂ₙ₊₃₊ₓ₇

The result of the analysis was -0.5 ≦ X7 ≦ 0.5 in all cases.

**Table 1**

| n | X1 | X2 | X3 | X4 | X5 | X6 | Jc |
|---|---|---|---|---|---|---|---|
| 2 | 0.5 | 0.3 | 0.1 | 0.1 | 0 | 0 | 50,000 |
| 2 | 0.5 | 0.3 | 0 | 0.2 | 0 | 0 | 60,000 |
| 2 | 0.6 | 0.3 | 0.1 | 0 | 0 | 0 | 60,000 |
| 2 | 0.5 | 0.5 | 0 | 0 | 0 | 0.2 | 70,000 |
| 3 | 0.8 | 0.2 | 0 | 0 | 0 | 0.3 | 110,000 |
| 3 | 0.6 | 0.1 | 0 | 0.1 | 0.2 | 0.4 | 120,000 |
| 3 | 0.5 | 0.2 | 0.1 | 0.2 | 0 | 0.5 | 130,000 |
| 3 | 0.4 | 0.3 | 0 | 0 | 0.3 | 0.6 | 100,000 |
| 3 | 0.6 | 0.1 | 0 | 0.1 | 0.2 | 0.7 | 110,000 |
| 3 | 0.5 | 0.2 | 0.1 | 0.2 | 0 | 0.8 | 140,000 |
| 3 | 0.6 | 0.4 | 0 | 0 | 0 | 1 | 90,000 |
| 4 | 0.6 | 0.3 | 0 | 0.1 | 0 | 0.3 | 110,000 |
| 4 | 0.5 | 0.2 | 0 | 0.3 | 0 | 0.2 | 80,000 |
| 4 | 0.4 | 0.5 | 0 | 0.1 | 0 | 0.1 | 100,000 |
| 5 | 0.7 | 0.3 | 0 | 0 | 0 | 0 | 90,000 |
| 5 | 0.9 | 0.1 | 0 | 0 | 0 | 0.5 | 90,000 |
| 5 | 0.5 | 0.5 | 0 | 0 | 0 | 0 | 80,000 |

Table 1 shows the Jc values (unit: A/cm²) measured at X1, X2, X3, X4, X5, X6, n and 77 K without magnetic field being applied.

It has been found out that use of any superconducting substance gives high Jc values.

### [Eleventh Embodiment]

Based on the procedure of the first embodiment but at different wire drawing and rolling temperature, inventors manufactured the superconducting wire. Fig. 9 illustrates the relationship between the wire drawing and rolling temperatures and the Jc at 77 K in non-magnetic field environment. It is noted that the rolling temperature of 50 - 250°C is preferable.

### [Twelfth Embodiment]

Based on the procedure of the first embodiment, inventors manufactured the superconducting wire at the heat treatment temperature optimized in the range of 30 degrees Celsius, using YBa₂Cu₂O_{6.9}, NdBa₂Cu₂O_{6.9}, SmBa₂Cu₂O_{6.9}, EuBa₂Cu₂O_{6.9}, GdBa₂Cu₂O_{6.9}, HoBa₂Cu₂O_{6.9}, ErBa₂Cu₂O_{6.9}, and YbBa₂Cu₂O_{6.9} as superconducting substances. The superconductive critical current density (Jc) of the sample measured after heat treatment was as high as 100,000 A/cm² at 77 K at zero magnetic field, and 50,000 A/cm² or more when lT magnetic field was applied perpendicular to the tape.

### [Thirteenth Embodiment]

Based on the procedure of the eighth embodiment, inventors manufactured the 100 m superconducting wire. The surface of this superconducting wire was coated with alumina to a thickness of about 5 microns, and was wound in pancake coils to manufacture eight superconducting coils. They were heaped in the lengthwise direction to make the superconducting magnet as shown in Fig. 10, wherein reference numeral 7 denoted power supply for excitation; 8, service port; 9, refrigerant outlet; 10, heat reflector; 11, liquid nitrogen; 12, laminated superconducting coil; and 13, cryostat. The coils were dipped in liquid nitrogen, to which electric current was applied thereby producing a maximum magnetic field of 3.1 Tesla.

### [Fourteenth Embodiment]

The superconducting magnet manufactured in thirteenth embodiment was used to manufacture the NMR device configured as shown in Fig. 11, to confirm that the nuclear magnetic resonance of hydrogen atom can be measured. In Fig. 11, reference numeral 15 denotes cryostat; 16, normal temperature bore; 17, superconducting coil; 18, magnetic shield; 19, power lead; 20, transmitting and receiving coil; 21, room temperature shim coil; and 22, sample. Compared with the devices available on the market which are operated by cooling with helium, this product allows heat insulation to be simplified; hence production cost can be cut by more than 10 percent. It is also made clear that this eliminates use of high-priced liquid helium, thereby ensuring substantial reduction in operation costs.

The NMR device and MRI device are fundamentally based on the same operating principle. It shows that MRI device can be manufactured by using the superconducting magnet made of the superconducting wire, which is produced with the superconductor manufactured according to the present invention. According to the production costs estimated, the helium cooled refrigerator can be replaced by the less costly nitrogen refrigerator featuring a simplified structure, and simplex heat insulation can be utilized. Furthermore, the operating temperature of 77 K is much higher than the operating temperature of 4.2 K in the conventional MRI device, and specific heat of the superconducting wire is increased by about 100. Therefore, there is no possibility of quenching, hence no need of taking countermeasures for it. These considerations have made it clear that the product according to the present invention can cut down costs by at least 20 percent.

### [Fifteenth Embodiment]

The inventors have manufactured the magnetic shield using the superconductors according to the present invention. The 3-cm-thick-superconducting plate was used to make a cubic. It was cooled by 78 K nitrogen gas to form shield superconducting state, and a magnetic field of 50 gauss was applied thereto from the outside. The Hall sensor placed inside was used to measure the magnetic field inside. It was shown that the magnetic field was too small to be measured by the Hall sensor. The internal magnetic field was about 1 gauss when the external magnetic field was 3000 gausses. This has confirmed that satisfactory characteristics are provided by the magnetic shield manufactured by the superconductor according to the present invention.

### [Sixteenth Embodiment]

The inventors have estimated cost reduction which can be achieved by using the magnet made of the superconducting wire according to the present invention to manufacture all four-pole magnets for particle beam concentration mounted on the ring of a large sized particle accelerator, for example, an accelerator having a ring diameter of 1 km, in comparison with the case of using the conventional superconducting magnet cooled by liquid helium to make said four-pole magnets. The result of the study has revealed that the product according to the present invention allows the helium cooled refrigerator to be replaced by the less costly nitrogen refrigerator featuring a simplified structure. It has also been shown that the system to supply refrigerant to the superconducting magnet can be much simplified because of simple and effective heat insulation and liquid nitrogen featuring a high specific heat. Furthermore, it has been clear that the product according to the present invention can cut down costs by at least 20 percent.

### [Seventeenth Embodiment]

The inventors have obtained high Jc values by using, in place of silver, the silver/gold alloy, silver/palladium alloy, silver/copper alloy, alloy reinforced with MgO dispersed on the silver matrix phase, and alloy reinforced with intermetallic compound dispersed on the silver matrix phase --- all having cubic texture --- according to the procedure of the first embodiment. The superconductive critical current density (Jc) of all these samples measured after heat treatment was 100,000 A/cm² at 77 K at zero magnetic field, and over 40,000 A/cm² when lT magnetic field was applied perpendicular to the tape.

The present invention provides the superconductor, superconducting wire, superconducting magnet and superconductor-based equipment which have high superconductive critical current density in a highly magnetic field and which are operated by cooling with liquid nitrogen as well as liquid helium. The superconductor-based equipment using the superconductor and superconducting wire according to the present invention can be driven by cooling with liquid nitrogen. Accordingly, the present invention not only replaces the superconducting portion by the conventional superconductor and superconduting wire, but when viewed as an entire system, the present invention provides a substantial simplification of the cooling system, insulation structure, countermeasures against quenching (against abrupt breakdown of the superconductor) and others.

## Claims

1. A superconducting wire comprising a composite of the metallic substance and superconducting substance wherein
(1) said superconducting substance is split by said metallic substance into a plurality of superconducting substance elements which are parallel to said wire in its longitudinal direction,
(2) the cross section perpendicular to said superconducting substance elements in the longitudinal direction has a flat form where the brachyaxis over macro-axis is equal to or smaller than 1.0, without the length of the brachyaxis exceeding 5 microns,
(3) said metallic substance is composed of silver, silver alloy or ceramics-reinforced silver, and
(4) chemical composition of said superconducting substance is expressed by:
(Tlₓ₁Pbₓ₂Biₓ₃Hgₓ₄Cuₓ₅)(Sr₁₋ₓ₆Baₓ₆)₂Caₙ₋₁CuₙO₂ₙ₊₃₊ₓ₇
where
0 ≦ X1 ≦ 1.0,
0 ≦ X2 ≦ 1.0,
0 ≦ X3 ≦ 0.5,
0 ≦ X4 ≦ 1.0,
0 ≦ X5 ≦ 1.0,
0.5 ≦ X1 + X2 + X3 + X4 + X5 ≦ 1,
0 ≦ X6 ≦ 1,
-0.5 ≦ X7 ≦ 0.5
n = 1, 2, 3, 4, 5.

2. A superconducting wire comprising a composite of the metallic substance and superconducting substance wherein
(1) said superconducting substance is split by said metallic substance into a plurality of superconducting substance elements which are parallel to said wire in its longitudinal direction,
(2) the cross section perpendicular to said superconducting substance elements in the longitudinal direction has a circular or flat form where the brachyaxis over macro-axis is equal to or smaller than 1.0, without the length of the brachyaxis exceeding 5 microns,
(3) said metallic substance is composed of silver, silver alloy or ceramics-reinforced silver,
(4) not less than 80 percent of the crystals of the silver or silver alloy forming the said metallic substance are uniformly oriented in one direction, without exceeding 10 degrees, and
(5) chemical composition of said superconducting substance is expressed by:
(Tlₓ₁Pbₓ₂Biₓ₃Hgₓ₄Cuₓ₅)(Sr₁₋ₓ₆Baₓ₆)₂Caₙ₋₁CuₙO₂ₙ₊₃₊ₓ₇
where
0 ≦ X1 ≦ 1.0,
0 ≦ X2 ≦ 1.0,
0 ≦ X3 ≦ 0.5,
0 ≦ X4 ≦ 1.0,
0 ≦ X5 ≦ 1.0,
0.5 ≦ X1 + X2 + X3 + X4 + X5 ≦ 1,
0 ≦ X6 ≦ 1,
-0.5 ≦ X7 ≦ 0.5
n = 1, 2, 3, 4, 5.

3. A superconducting wire comprising a composite of the metallic substance and superconducting substance wherein
(1) said superconducting substance is split by said metallic substance into a plurality of superconducting substance elements which are parallel to said wire in its longitudinal direction,
(2) the cross section perpendicular to said superconducting substance elements in the longitudinal direction has a circular or flat form where the brachyaxis over macro-axis is equal to or smaller than 1.0, without the length of the brachyaxis exceeding 5 microns,
(3) said metallic substance is composed of silver, silver alloy or ceramics-reinforced silver,
(4) surface {110} of not less than 80 percent of the crystals of the silver or silver alloy forming the said metallic substance is parallel to the boundary between said metallic substance and said superconducting substance elements, without exceeding 5 degrees,
(5) direction 〈211〉 is oriented in the longitudinal direction of said superconducting wire without exceeding 10 degrees, and
(6) chemical composition of said superconducting substance is expressed by:
(Tlₓ₁Pbₓ₂Biₓ₃Hgₓ₄Cuₓ₅)(Sr₁₋ₓ₆Baₓ₆)₂Caₙ₋₁CuₙO₂ₙ₊₃₊ₓ₇
where
0 ≦ X1 ≦ 1.0,
0 ≦ X2 ≦ 1.0,
0 ≦ X3 ≦ 0.5,
0 ≦ X4 ≦ 1.0,
0 ≦ X5 ≦ 1.0,
0.5 ≦ X1 + X2 + X3 + X4 + X5 ≦ 1,
0 ≦ X6 ≦ 1,
-0.5 ≦ X7 ≦ 0.5
n = 1, 2, 3, 4, 5.

4. A superconducting wire comprising a composite of the metallic substance and superconducting substance wherein
(1) said superconducting substance is split by said metallic substance into a plurality of superconducting substance elements which are parallel to said wire in its longitudinal direction,
(2) the cross section perpendicular to said superconducting substance elements in the longitudinal direction has a circular or flat form where the brachyaxis over macro-axis is equal to or smaller than 1.0, without the length of the brachyaxis exceeding 5 microns,
(3) said metallic substance is composed of silver, silver alloy or ceramics-reinforced silver,
(4) surface {110} of not less than 80 percent of the crystals of the silver or silver alloy forming the said metallic substance is parallel to the boundary between said metallic substance and said superconducting substance elements, without exceeding 5 degrees,
(5) direction 〈211〉 is oriented in the longitudinal direction of said superconducting wire without exceeding 10 degrees,
(6) chemical composition of said superconducting substance is expressed by:
(Tlₓ₁Pbₓ₂Biₓ₃Hgₓ₄Cuₓ₅)(Sr₁₋ₓ₆Baₓ₆)₂Caₙ₋₁CuₙO₂ₙ₊₃₊ₓ₇
where
0 ≦ X1 ≦ 1.0,
0 ≦ X2 ≦ 1.0,
0 ≦ X3 ≦ 0.5,
0 ≦ X4 ≦ 1.0,
0 ≦ X5 ≦ 1.0,
0.5 ≦ X1 + X2 + X3 + X4 + X5 ≦ 1,
0 ≦ X6 ≦ 1,
-0.5 ≦ X7 ≦ 0.5
n = 1, 2, 3, 4, 5
(7) the c-axis of the crystal of not less than 80 percent of the superconducting substance is perpendicular to the boundary between said metallic substance and said superconducting substance elements without exceeding 5 degrees, and
(8) the a-axis is oriented parallel to the direction 〈100〉 of the silver crystal without exceeding 10 degrees.

5. A superconducting wire comprising a composite of the metallic substance and superconducting substance wherein
(1) said superconducting substance is split by said metallic substance into a plurality of superconducting substance elements which are parallel to said wire in its longitudinal direction,
(2) the cross section perpendicular to said superconducting substance elements in the longitudinal direction has a circular or flat form where the brachyaxis over macro-axis is equal to or smaller than 1.0, without the length of the brachyaxis exceeding 5 microns,
(3) said metallic substance is composed of silver, silver alloy or ceramics-reinforced silver,
(4) surface {100} of not less than 80 percent of the crystals of the silver or silver alloy forming the said metallic substance is parallel to the boundary between said metallic substance and said superconducting substance elements, without exceeding 5 degrees,
(5) direction 〈001〉 is oriented in the longitudinal direction of said superconducting wire without exceeding 10 degrees, and
(6) chemical composition of said superconducting substance is expressed by:
(Tlₓ₁Pbₓ₂Biₓ₃Hgₓ₄Cuₓ₅)(Sr₁₋ₓ₆Baₓ₆)₂Caₙ₋₁CuₙO₂ₙ₊₃₊ₓ₇
where
0 ≦ X1 ≦ 1.0,
0 ≦ X2 ≦ 1.0,
0 ≦ X3 ≦ 0.5,
0 ≦ X4 ≦ 1.0,
0 ≦ X5 ≦ 1.0,
0.5 ≦ X1 + X2 + X3 + X4 + X5 ≦ 1,
0 ≦ X6 ≦ 1,
-0.5 ≦ X7 ≦ 0.5
n = 1, 2, 3, 4, 5.

6. A superconducting wire comprising a composite of the metallic substance and superconducting substance wherein
(1) said superconducting substance is split by said metallic substance into a plurality of superconducting substance elements which are parallel to said wire in its longitudinal direction,
(2) the cross section perpendicular to said superconducting substance elements in the longitudinal direction has a circular or flat form where the brachyaxis over macro-axis is equal to or smaller than 1.0, without the length of the brachyaxis exceeding 5 microns,
(3) said metallic substance is composed of silver, silver alloy or ceramics-reinforced silver,
(4) surface {100} of not less than 80 percent of the crystals of the silver or silver alloy forming the said metallic substance is parallel to the boundary between said metallic substance and said superconducting substance elements, without exceeding 5 degrees,
(5) direction 〈001〉 is oriented in the longitudinal direction of said superconducting wire without exceeding 10 degrees,
(6) chemical composition of said superconducting substance is expressed by:
(Tlₓ₁Pbₓ₂Biₓ₃Hgₓ₄Cuₓ₅)(Sr₁₋ₓ₆Baₓ₆)₂Caₙ₋₁CuₙO₂ₙ₊₃₊ₓ₇
where
0 ≦ X1 ≦ 1.0,
0 ≦ X2 ≦ 1.0,
0 ≦ X3 ≦ 0.5,
0 ≦ X4 ≦ 1.0,
0 ≦ X5 ≦ 1.0,
0.5 ≦ X1 + X2 + X3 + X4 + X5 ≦ 1,
0 ≦ X6 ≦ 1,
-0.5 ≦ X7 ≦ 0.5
n = 1, 2, 3, 4, 5
(7) the c-axis of the crystal of not less than 80 percent of the superconducting substance is perpendicular to the boundary between said metallic substance and said superconducting substance elements without exceeding 5 degrees, and
(8) the a-axis is oriented parallel to the direction 〈100〉 of the silver crystal without exceeding 10 degrees.

7. A superconducting wire according to any one of Claims 1 through 6 wherein the chemical composition of said superconducting substance is expressed by LnBa₂Cu₃O₇₊ₓ₁
wherein Ln is Y, or one or more types selected from rare earth
-0.5 ≦ X1 ≦ 0.2
n = 1, 2, 3.

8. A superconducting wire according to any one of Claims 1 through 6 wherein
(1) the chemical composition of said superconducting substance is expressed by LnBa₂Cu₃O₇₊ₓ₁
wherein Ln is Y, or one or more types selected from rare earth
n = 1, 2, 3,
(2) the c-axis of the crystal of not less than 80 percent of the superconducting substance is perpendicular to the boundary between said metallic substance and said superconducting substance elements without exceeding 5 degrees, and
(3) the b-axis, or either the a-axis or b-axis is oriented parallel to the direction 〈100〉 of the silver crystal without exceeding 10 degrees.

9. A superconducting wire according to any one of Claim 1 through 8 wherein the purity of silver is not less than 99.99 percent.

10. A superconducting material manufacturing method comprising the steps of:
(1) manufacturing a composite tube filling with the superconducting substance or the substance which is converted into the superconducting substance by heat treatment, the tube which is made of the silver, silver alloy, or silver reinforced with ceramics,
(2) drawing the composite tube in the longitudinal direction by reducing the cross section of said composite tube,
(3) hot-working said composite tube at the temperature of not less than 50 degrees Celsius without exceeding 250 degrees Celsius, and
(4) effecting heat treatment at the temperature of not less than 800 degrees Celsius.

11. A superconducting material manufacturing method comprising:
(1) manufacturing a composite tube filling with the superconducting substance or the substance which is converted into the superconducting substance by heat treatment, the tube which is made of the hollow silver, silver alloy or silver reinforced with ceramics,
(2) drawing composite tube in the longitudinal direction by reducing the cross section of said composite tube,
(3) hot-working to flatten said composite tube in a flat form at the temperature of not less than 50 degrees Celsius without exceeding 250 degrees Celsius, and
(4) effecting heat treatment at the temperature of not less than 800 degrees Celsius.
